# EUROPÄISCHE PATENTSCHRIFT

(11) **EP 0 780 672 B1**
(45) Veröffentlichungstag und Bekanntmachung des Hinweises auf die Patenterteilung: **02.04.2003**
(21) Anmeldenummer: 96119029.5
(22) Anmeldetag: 27.11.1996
(51) Int. Cl.: G01K 7/01

(54) **Durch Feldeffekt steuerbares Leistungs-Halbleiterbauelement mit Temperatursensor**
Field effect controllable semiconductor device with temperature sensor
Dispositif semi-conducteur contrôlable par effet de champ, à capteur de température

(30) Priorität: 21.12.1995 DE 19548060
(43) Veröffentlichungstag der Anmeldung: 25.06.1997
(73) Patentinhaber: Infineon Technologies AG, 81669 München (DE)
(72) Erfinder: Gantioler, Josef-Matthias, 81925 München (DE); Heil, Holger, 80805 München (DE); Krischke, Norbert, 80638 München (DE)
(74) Vertreter: Bickel, Michael

(56) Entgegenhaltungen:
- EP-A- 0 240 807
- EP-A- 0 409 214
- US-A- 5 237 481

## Beschreibung

Die Erfindung bezieht sich auf ein durch Feldeffekt steuerbares, eine Vielzahl von einander parallel geschalteten Zellen aufweisendes Leistungs-Halbleiterbauelement mit einem einen Bipolartransistor enthaltenden Temperatursensor, der dem Zellenfeld des Leistungs-Halbleiterbauelementes benachbart angeordnet ist, mit den Merkmalen:
a) Die Basiszone des Bipolartransistors und die Gatezonen des Leistungs-Halbleiterbauelements sind vom gleichen Leitungstyps,
b) die Kollektorzone des Bipolartransistors und die Drainzone des Leistungs-Halbleiterbauelementes sind durch eine einzige Zone des Halbleiterkörpers des Leistungs-Halbleiterbauelementes gebildet.

Leistungs-Halbleiterbauelemente der genannten Art sind z.B. in Form sogenannter SMART-FET auf dem Markt. Das Prinzip eines Temperatursensors der genannten Art ist z.B. in der EP 0 240 807 beschrieben worden. Der Temperatursensor enthält einen in Sperrichtung gepolten Bipolartransistor, dem ein als Konstantstromquelle geschalteter Depletion-FET in Reihe geschaltet ist. Dieser Temperatursensor ist thermisch mit dem Leistungs-Halbleiterbauelementes dadurch gekoppelt, daß er benachbart, z.B. in einer Aussparung des Zellenfeldes angeordnet ist.

Der Strom der Konstantstromquelle ist nun so eingestellt, daß er höher ist als derjenige Sperrstrom des Bipolartransistors, der bei der normalen Betriebstemperatur des Leistungs-Halbleiterbauelementes fließt. Er ist jedoch niedriger als derjenige Sperrstrom, der bei Übertemperatur des Leistungs-Halbleiterbauelementes fließt. Beim Übergang von normaler Betriebstemperatur auf Übertemperatur tritt dann am Depletion-MOSFET ein ausgeprägter Spannungsanstieg ein, der die Übertemperatur signalisiert.

Der Temperatursensor kann als Chip auf dem Halbleiterkörper des Leistungs-Halbleiterbauelementes montiert werden oder erwird im gleichen Halbleiterkörper monolithisch integriert. Bei der monolithisch integrierten Lösung sind die Basiszone des Bipolartransistors und die Gatezonen des Leistungs-Halbleiterbauelementes vom gleichen Leitungstyp. Die Kollektorzone des Bipolartransistors und die Drainzone des Leistungs-Halbleiterbauelementes sind durch eine einzige Zone des Halbleiterkörpers des Leistungs-Halbleiterbauelementes gebildet.

Wie erwähnt, wird der Strom des in Sperrichtung gepolten Bipolartransistors durch die Erhöhung der Temperatur des Leistungs-Halbleiterbauelementes größer. Dieser Strom setzt sich aus dem eigentlichen Sperrstrom des Bipolartransistors und einem Diffusionsstrom zusammen, der durch den Konzentrationsunterschied der Minoritätsladungsträger zwischen der Grenz der Raumladungszone des Leistungs-Halbleiterbauelementes einerseits und der Grenze der Raumladungszone des Bipolartransistors andererseits erzeugt wird. Dieser Diffusionsstrom ist damit nicht nur temperaturabhängig, sondern hängt auch vom Potential des Sourceanschlusses des Leistungs-Halbleiterbauelementes ab. Bei Leistungs-Halbleiterbauelementen mit sourceseitiger Last wird die Größe des Diffusionsstroms daher auch davon beeinflußt, ob die Last im Normalzustand ist oder ganz oder teilweise kurzgeschlossen ist. Damit wird der Transistorstrom nicht nur temperaturabhängig, sondern auch lastabhängig. Eine einwandfreie Erfassung der Übertemperatur ist damit nicht möglich.

Die EP 0 550 850 A2 beschreibt einen vertikalen Leistungstransistor mit einem monolithisch integrierten Temperatursensor, der aus zwei Sensorzellen besteht, die zusammen mit dem Leistungstransistor herstellbar sind, wobei im Bereich der Sensorzellen ein lateraler Bipolartransistor gebildet ist.

Die US 5,237,481 beschreibt einen Leistungstransistor mit einem monolithisch integrierten Diodenanordnung, die als Temperatursensor dient.

Der Erfindung liegt die Aufgabe zugrunde, ein durch Feldeffekt steuerbares Leistungs-Halbleiterbauelement der beschriebenen Art so weiterzubilden, daß die Temperaturerfassung unabhängig vom Source-Potential des Leistungs-Halbleiterbauelements ist.

Dieses Ziel wird durch ein Halbleiterbauelement gemäß den Merkmalen des Anspruchs 1 gelöst.

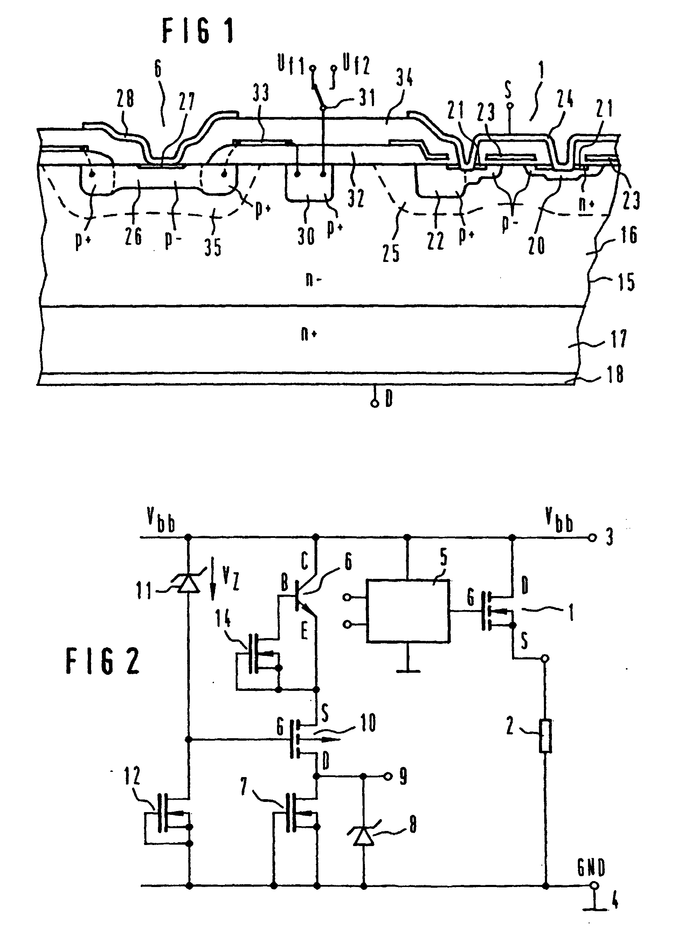

Die Erfindung wird anhand eines Ausführungsbeispiels in Verbindung mit den Figuren 1 und 2 näher erläutert. Es zeigen
- Figur 1: den Schnitt durch ein erfindungsgemäßes Leistungs-Halbleiterbauelement und
- Figur 2: die Schaltungsanordnung eines bekannten Temperatursensors zur Erfassung der Übertemperatur eines Leistungs-Halbleiterbauelementes 1, in der die Erfindung angewendet werden kann.

Das Leistungs-Halbleiterbauelement nach Figur 1 hat einen Halbleiterkörper 15 mit einer schwach n-dotierten Drainzone 16. An die Zone 16 grenzt eine stark n-dotierte Zone 17, deren Oberfläche durch eine Drainelektrode 18 kontaktiert ist. In die andere Oberfläche des Halbleiterkörpers ist eine p-dotierte Gatezone 20 eingebettet, in die wiederum eine stark n-dotierte Sourcezone 21 eingebettet ist. Die Gatezone ist von einer Gateelektrode 23 überdeckt, die auf einer Isolierschicht angeordnet ist. Die Gatezone 20 und die Sourcezone 21 ist durch eine Sourceelektrode 24 kontaktiert. Sie ist mit einem Sourceanschluß S verbunden.

Die Gatezone 20 und die Sourcezone 21 bildet eine Zelle des Leistungs-Halbleiterbauelementes. Auf dem Halbleiterkörper ist eine Vielzahl von Zellen angeordnet. Alle Zellen sind einander durch die Sourceelektrode 24 parallel geschaltet. Die Gateelektrode 23 ist ebenfalls allen Zellen gemeinsam.

Die Drainzone aller Zellen wird durch die Zone 16 des Halbleiterkörpers 15 gebildet.

Benachbart der gezeigten Zelle ist eine Randzelle angeordnet, die aus einer Gatezone 22 und einer Sourcezone 21 besteht. Auch diese Zonen sind durch die Sourceelektrode 24 kontaktiert. Die Gatezone 22 ist tiefer als die Gatezone 20 ausgebildet, hierdurch wird in Verbindung mit der dargestellten Feldelektrode auf bekannte Art und Weise ein günstiger Verlauf der Raumladungszone an der Oberfläche des Halbleiterkörpers eingestellt. Die genannten Zonen bilden einen Leistungs-MOSFET.

In die sourceseitige Oberfläche des Halbleiterkörpers 15 ist außerdem eine p-dotierte Basiszone 26 eingebettet, in die wiederum eine n-dotierte Emitterzone 27 eingebettet ist. Die Emitterzone ist durch eine Emitterelektrode 28 kontaktiert. Diese Zonen bilden zusammen mit der Zone 16 als Kollektorzone einen Bipolartransistor, der mit 6 bezeichnet ist.

Zwischen dem Leistungs-Halbleiterbauelement 1 und dem Bipolartransistor 6 ist in die source- bzw. emitterseitige Oberfläche des Halbleiterkörpers 15 eine p-dotierte Zone 30 eingebettet. Diese Zone ist kontaktiert und mit einem Anschluß 31 verbunden, an den eine feste oder wahlweise unterschiedliche feste Vorspannungen anlegbar sind. Der Abstand zwischen der Zone 30 und dem Bipolartransistor 6 einerseits und zwischen der Zone 30 und dem Leistungs-Halbleiterbauelement 1 andererseits ist so gewählt, daß ihre durch die gestrichelten Linien begrenzten Raumladungszonen 35 bzw. 25 nicht an die Zone 30 stoßen. Die Zone 30 ist zweckmäßigerweise gleich tief und gleich stark dotiert wie der tiefe Teil der Basiszone 22.

Zur Erläuterung der Wirkungsweise der Anordnung wird zunächst davon ausgegangen, daß die p-dotierte Zone 30 nicht vorhanden ist. Bei eingeschaltetem Leistungs-Halbleiterbauelement 1 und Normalzustand der Last 2 liegt am Sourceanschluß von 1 das Potential V_{bb}. Der pn-Übergang zwischen den Zonen 16 und 22 ist damit nicht gesperrt und die Minoritätsträger-Ladungsdichte ist an seiner Kante damit im thermischen Gleichgewicht (pₙₒ) und nur von der Temperatur abhängig. Der pn-Übergang des Bipolartransistors zwischen den Zonen 26 und 16 ist in Sperrichtung vorgespannt, die Minoritätsträger-Ladungsdichte ist hier daher abgesenkt. Aufgrund des Konzentrationsgradienten fließt ein Diffusionsstrom vom Rand der Raumladungszone 35 in den Bipolartransistor 6.

Erniedrigt sich das Sourcepotential von 1 z.B. durch einen Kurzschluß der Last 2, so wird der pn-Übergang zwischen 22 und 16 in Sperrichtung gepolt und die Minoritätsträger-Ladungsdichte am Rand der Raumladungszone 25 wird abgesenkt. Liegt der Abstand der p-Gebiete 22 und 26 in der Größenordnung der Diffusionslänge, so wird die Minoritatsträger-Ladungsdichte im ganzen Bereich zwischen 22 und 26 abgesenkt. Damit sinkt der Diffusionsstrom in den Bipolartransistor 6 abhängig vom Sourcepotential an 1 und eine Übertemperatur ließe sich nicht eindeutig erfassen.

Eine wirksame Abhilfe läßt sich durch die Zone 30 erreichen, die an einer festen Vorspannung angeschlossen ist. Liegt die Zone 30 z.B. am Potential V_{bb}, stellt sich an ihrem pn-Übergang eine Dichte an Minoritätsladungsträgern ein, die dem thermischen Gleichgewicht entspricht. Am Rand des vorgespannten pn-Übergangs zwischen den Zonen 26 und 16 ist die Dichte abgesenkt, es fließt daher wie oben beschrieben ein Diffusionsstrom in den Bipolartransistor 6. Da die Dichte der Minoritätsladungsträger in der Umgebung der Zone 30 sowohl zwischen 30 und der Raumladungszone 25 als auch zwischen 30 und der Raumladungszone 35 in thermischem Gleichgewicht ist, ist der Diffusionsstrom in den Bipolartransistor 6 unabhängig vom Sourcepotential am Leistungs-Halbleiterbauelement 1.

Die Wirkung der Zone 30 kann noch dadurch verbessert werden, daß die Oberfläche des Halbleiterkörpers zwischen der Zone 30 und der Basiszone 26 mit einer Feldelektrode 33 bedeckt wird, die ihrerseits auf einer Isolierschicht 32 angeordnet ist. Die Feldelektrode 33 kann ihrerseits durch eine Isolierschicht 34 bedeckt sein, auf der die Emitterelektrode 28 und die Sourceelektrode 24 liegt. Die Feldelektrode 33 kann entweder mit der Zone 30 oder mit der Basiszone 26 elektrisch verbunden sein. Damit ist es möglich, die Potentiale an der Oberfläche des Halbleiterkörpers einzustellen. Je nachdem, ob die Feldelektroden 33 mit der Zone 30 oder mit der Basiszone 26 verbunden ist, wirkt die Zonenfolge 26, 16, 30 als MOS-Diode oder als gesperrter Transistor.

Die Zone 30 kann, anstatt nur mit einer einzigen festen Vorspannung verbunden zu werden, wahlweise auch an mehrere, hier an zwei, feste Vorspannungen U_{f1}, U_{f2} unterschiedlicher Höhe angeschlossen werden. Damit ist die Höhe des Diffusionsstroms einstellbar. Dabei gilt, daß die Ansprechschwelle des Temperatursensors mit niedrigerer Vorspannung zu höheren Temperaturen hin verschoben wird, während sie bei höherer Vorspannung zu niedrigeren Temperaturen hin verschoben wird. Durch Umschalten der Vorspannungen ist es demnach möglich, eine Schalthysterese des Temperatursensors einzustellen.

Die Schaltungsanordnung nach Figur 2 enthält das Leistungs-Halbleiterbauelement 1 und den Temperatursensor mit dem Bipolartransistor 6. Dem Bipolartransistor 6 ist emitterseitig ein p-Kanal-MOSFET 10 und eine Stromquelle 7 in Reihe geschaltet. Die Stromquelle besteht vorteilhafterweise aus einem Depletion-FET, dessen Gateanschluß mit dem Sourceanschluß verbunden ist. Ihm ist eine Zenerdiode 8 parallel geschaltet. Der Knoten zwischen den MOSFET 7 und 10 ist mit einem Ausgang 9 verbunden. Der Reihenschaltung aus 6, 10 und 7 ist die Reihenschaltung aus einer Zenerdiode 11 und einem zweiten, als Stromquelle geschalteten Depletion-FET 12 parallelgeschaltet. Der Knoten zwischen 11 und 12 ist mit dem Gateanschluß G von 10 verbunden. Zwischen Basisanschluß und Emitteranschluß des Bipolartransistors kann eine Stromquelle 14 geschaltet sein, die so dimensioniert ist, daß sie bei einem bei Normaltemperatur fließenden Basisstrom einen Kurzschluß bildet, jedoch oberhalb dieser Temperatur hochohmig wird. Damit wird der Temperatursensor unempfindlich gegen Störungen z.B. durch Spannungsschwankungen.

Das Leistungs-Halbleiterbauelement 1 ist ein Leistungs-MOSFET. Ihm ist sourceseitig eine Last 2 in Reihe geschaltet. Es wird durch eine Ansteuerschaltung 5 gesteuert, dessen Ausgang mit dem Gateanschluß von 1 verbunden ist.

Die Schaltung, die im Prinzip z.B. im US-Patent 4,875, 131 beschrieben ist, hat folgende Wirkungsweise: Der Gateanschluß von 10 liegt über die Diode 11 und den MOSFET 12 an einem konstanten Potential V_{bb}-U_{Z}. Am Bipolartransistor 6 liegt dann eine konstante Spannung U_{Z}-Vₜₕ₁₀ an. Der Depletion-FET 7 ist so dimensioniert, daß sein Sättigungsstrom bei normaler Betriebstemperatur des Halbleiterbauelements 1 größer ist als der Sperrstrom des Bipolartransistors 6. Das Potential am Ausgang 9 liegt dann etwa auf Massepotential. Mit steigender Temperatur des Leistungs-Halbleiterbauelementes steigt der Sperrstrom des Bipolartransistors 6 exponentiell mit der Temperatur an. Bei Erreichen der Übertemperatur überschreitet der Sperrstrom des Bipolartransistors 6 den Sättigungsstrom des MOSFET 7. Damit tritt am Ausgang 9 ein Spannungsanstieg ein, der Übertemperatur anzeigt. Die Spannung wird durch die Zenerdiode 8 begrenzt.

Die Erfindung ist unabhängig von der in Figur 2 dargestellten Schaltungsanordnung überall in monolithisch integrierten Schaltungen zu verwenden.

Die Erfindung kann auch für IGBT verwendet werden. Dabei ist die stark n-dotierte Zone 17 im Bereich des MOSFET 1 durch eine stark p-dotierte Zone ersetzt.

## Patentansprüche

1. Durch Feldeffekt steuerbares, eine Vielzahl von zueinander parallel geschalteten Zellen aufweisendes Leistungs-Halbleiterbauelement (1) mit einem einen Bipolartransistor (6) enthaltenden Temperatursensor, der dem Zellenfeld des Leistungs-Halbleiterbauelementes benachbart angeordnet ist, mit den Merkmalen:
a) Die Basiszone (26) des Bipolartransistors und die Gatezonen (20) des Leistungs-Halbleiterbauelementes sind vom gleichen Leitungstyp,
b) die Kollektorzone des Bipolartransistors und die Drainzone des Leistungs-Halbleiterbauelementes sind durch eine einzige Zone (16) des Halbleiterkörpers (15) des Leistungs-Halbleiterbauelements gebildet,
**dadurch gekennzeichnet, daß** zwischen der Basiszone des Bipolartransistors und den Gatezonen der Zellen des Leistungs-Halbleiterbauelementes mindestens eine Zone (30) des gleichen Leitungstyps angeordnet ist und daß diese Zone (30) an eine feste Vorspannung (Uf) angeschlossen ist, die kleiner oder gleich der am Leistungs-Halbleiterbauelement liegenden Versorgungsspannung (Vbb) ist, wobei die Oberfläche des Halbleiterkörpers zwischen der Basiszone (26) des Bipolartransistors und der Zone (30) mit einer gegen die Oberfläche des Halbleiterkörpers isolierten Elektrode (33) bedeckt ist und wobei diese Elektrode (33) elektrisch entweder mit der Zone (30) oder der Basiszone (26) verbunden ist.

2. Leistungs-Halbleiterbauelement nach Anspruch 1,
**dadurch gekennzeichnet, daß** die feste Vorspannung zwischen zwei unterschiedlichen Spannungswerten (Uf1, Uf2) umschaltbar ist.

3. Leistungs-Halbleiterbauelement nach Anspruch 1 oder 2,
**dadurch gekennzeichnet, daß** die Zone (30) mindestens so hoch dotiert ist wie die Gatezonen (20, 22).

4. Leistungs-Halbleiterbauelement nach einem der Ansprüche 1 bis 3,
**dadurch gekennzeichnet, daß** die Zone (30) mindestens so tief ist wie die Gatezonen (20, 22).

5. Leistungs-Halbleiterbauelement nach einem der Ansprüche 1 bis 5,
**dadurch gekennzeichnet, daß** die Elektrode (33) aus dotiertem Polysilizium besteht.

6. Leistungs-Halbleiterbauelement nach einem der Ansprüche 1 bis 6,
**dadurch gekennzeichnet, daß** zwischen dem Basisanschluß (B) und dem Emitteranschluß (E) des Bipolartransistors (26) ein stromabhängiger Widerstand (14) angeschlossen ist, der unterhalb eines vorgegebenen Stroms einen ersten Widerstandswert und bei Überschreiten des vorgegebenen Stroms einen zweiten, höheren Widerstandswert hat.

## Claims

1. A field effect controllable semi-conductor device (1), having a large number of cells interconnected in parallel, with a temperature sensor including a bipolar transistor (6), contrived so as to adjoin the cell field of the semi-conductor device, with the following features:
a) The base zone (26) of the bipolar transistor and the gate zones (20) of the semi-conductor device are of the same conductivity type,
b) the collector zone of the bipolar transistor and the drain zone of the semi-conductor device are formed from a single zone (16) of the semi-conductor body of the semi-conductor device,
***characterised in that*** there is at least one zone (30) of the same conductivity type between the base zone of the bipolar transistor and the gate zones of the cells of the semi-conductor device, with this zone (30) connected to a fixed potential (U_{f}) , which is less than or equal to the supply voltage (V_{bb}) to the semi-conductor device, where the surface of the semi-conductor device between the base zone (26) of the bipolar transistor and the zone (30) is covered with an insulated electrode (33) in contact with the surface of the semi-conductor device, and where this electrode (33) is connected electrically with the zone (30) or the base zone (26).

2. Semi-conductor device as in Claim 1, ***characterised in that*** the fixed voltage is switchable between two different voltages (U_{f1}, U_{f2}).

3. Semi-conductor device as in Claim 1 or 2, ***characterised in that*** the zone (30) is doped to at least the same degree as the gate zones (20, 22).

4. Semi-conductor device as in any of Claims 1 to 3, ***characterised in that*** the zone (30) is at least as deep as the gate zones (20, 22).

5. Semi-conductor device as in any of Claims 1 to 4, ***characterised in that*** the electrode (33) is made from doped polysilicon.

6. Semi-conductor device as in any of Claims 1 to 3, ***characterised in that*** a resistor (14), whose value is dependent on the current passing through it, is connected between the base connection (B) and the emitter connection (E) of the bipolar transistor (26), with a primary value of resistance below a predetermined current and a second, higher value of resistance if the predetermined current is exceeded.

## Revendications

1. Composant semi-conducteur de puissance (1) commandé par effet de champ, comportant un grand nombre de cellules branchées en parallèle, et ayant un capteur de température comportant un transistor bipolaire (6), ce capteur étant installé dans le champ des cellules du composant semi-conducteur de puissance, et ayant les caractéristiques suivantes :
a) la zone de base (26) du transistor bipolaire et les zones de porte (20) du composant semi-conducteur de puissance sont du même type de conductivité,
b) la zone de collecteur du transistor bipolaire et la zone de drain du composant semi-conducteur de puissance sont formées par une zone unique (16) du corps semi-conducteur (15) du composant semi-conducteur de puissance,
**caractérisé en ce qu'**
au moins une zone (30) de même type de conductivité est prévue entre la zone de base du transistor bipolaire et les zones de porte des cellules du composant semi-conducteur de puissance, et
cette zone (30) est reliée à une tension de polarisation fixe (Uf) inférieure ou égale à la tension de polarisation (Vbb) appliquée au composant semi-conducteur de puissance,
la surface du corps semi-conducteur entre la zone de base (26) du transistor bipolaire et la zone (30) étant couverte par une électrode (33) isolée par rapport à la surface du corps semi-conducteur, et
cette électrode (33) est reliée électriquement soit à la zone (30) soit à la zone de base (26).

2. Composant semi-conducteur de puissance selon la revendication 1,
**caractérisé en ce que**
la tension de polarisation fixe peut commuter entre deux niveaux de tension différents (Uf1, Uf2).

3. Composant semi-conducteur de puissance selon les revendications 1 ou 2,
**caractérisé en ce que**
la zone (30) est dopée à un niveau au moins aussi élevé que les zones de porte (20, 22).

4. Composant semi-conducteur de puissance selon les revendications 1 à 3,
**caractérisé en ce que**
la zone (30) est au moins aussi profonde que les zones de porte (20, 22).

5. Composant semi-conducteur de puissance selon les revendications 1 à 4,
**caractérisé en ce que**
l'électrode (33) est en polysilicium dopé.

6. Composant semi-conducteur de puissance selon les revendications 1 à 5,
**caractérisé en ce qu'**
une résistance (14) de valeur dépendant de l'intensité est branchée entre la borne de base (B) et la borne d'émetteur (E) du transistor bipolaire (26), et en dessous d'une intensité prédéterminée cette résistance a une première valeur et si l'intensité dépasse un niveau prédéterminé, la résistance a une seconde valeur plus élevée.
